# EUROPEAN PATENT APPLICATION

(11) **EP 1 737 043 A2**
(43) Date of publication of application: **27.12.2006**
(21) Application number: 06012426.0
(22) Date of filing: 16.06.2006
(51) Int. Cl.: H01L 29/78, H02J 7/00, H01L 21/336

(54) **Insulated gate-type semiconductor device and manufacturing method of the same**

(30) Priority: 22.06.2005 JP 2005182487
(71) Applicant: Sanyo Electric Co., Ltd, Moriguchi-city Osaka (JP)
(72) Inventor: Ishida, Hiroyasu, Ora-gun, Gunma 370-0523 (JP); Mandai, Tadao, Gunma 370-0524 (JP); Ushida, Atsuya, Ora-gun, Gunma 370-0524 (JP); Saito, Hiroaki, Gunma 373-0038 (JP)
(74) Representative: Glawe, Delfs, Moll

(57) **Abstract**

A first electrode layer (14), which comes into contact with a source region (12), and a second electrode layer (15), which comes into contact with a body (back gate) region (13), are provided. The first and second electrode layers (14, 15) are insulated from each other and are extended in a direction different from an extending direction of a trench (5). It is possible to individually apply potentials to the first and second electrode layers (14, 15), and to perform control for preventing a reverse current caused by a parasitic diode. Therefore, a bidirectional switching element can be realized by use of one MOSFET.

## Description

### BACKGROUND OF THE INVENTION

### Field of the Invention:

This invention relates to an insulated gate semiconductor device and a manufacturing method thereof. More particularly, the invention relates to an insulated gate semiconductor device which enables bidirectional switching operations within one chip by separating a back gate, and a manufacturing method thereof.

### Description of the Related Art:

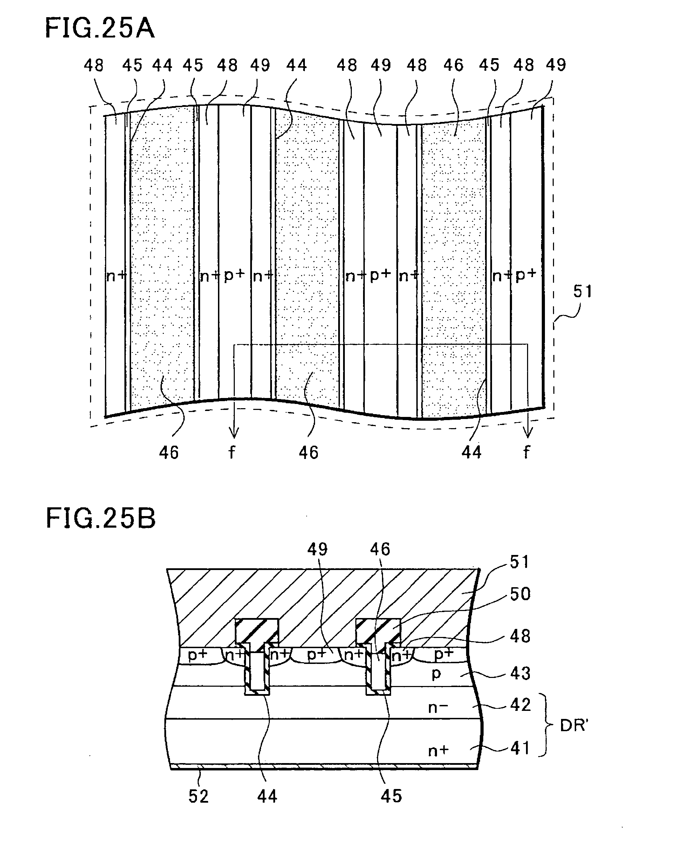

Figs. 25A and 25B show an n-channel MOSFET as an example of a conventional semiconductor device. Fig. 25A is a plan view, and Fig. 25B is a cross-sectional view along line f-f in Fig. 25A. Note that, in Fig. 25A, an interlayer insulating film is omitted and a source electrode is indicated by a broken line.

As shown in Fig. 25A, in a surface of a substrate, trenches 44 are formed in a stripe pattern, and source regions 48 and body regions 49 are disposed adjacent to the trenches 44. The trenches 44, the source regions 48 and the body regions 49 are extended in the same direction.

As shown in Fig. 25B, the n-channel MOSFET is formed in the following manner. A drain region DR' is provided by laminating an n- type epitaxial layer 42 on an n+ type semiconductor substrate 41. Thereafter, a p type channel layer 43 is provided on the drain region DR'. Subsequently, the trench 44 that reaches the n- type epitaxial layer 42 from a surface of the channel layer 43 is provided, and an inner wall of the trench 44 is covered with a gate oxide film 45. Thereafter, a gate electrode 46 is buried in the trench 44.

In the surface of the channel layer 43 adjacent to the trench 44, the n+ type source region 48 is formed. In the surface of the channel layer 43 between the source regions 48 of two adjacent cells, the p+ type body region 49 is formed. An interlayer insulating film 50 covers the trench 44, and a source electrode 51 is provided thereon, which comes into contact with the source region 48 and the body region 49. The source electrode 51 is continuously provided on the source region 48 and the body region 49. Moreover, on a rear surface of the substrate, a drain electrode 52 is provided.

The MOSFET described above is used, for example, in a protection circuit device which performs battery management such as charge and discharge of a secondary battery.

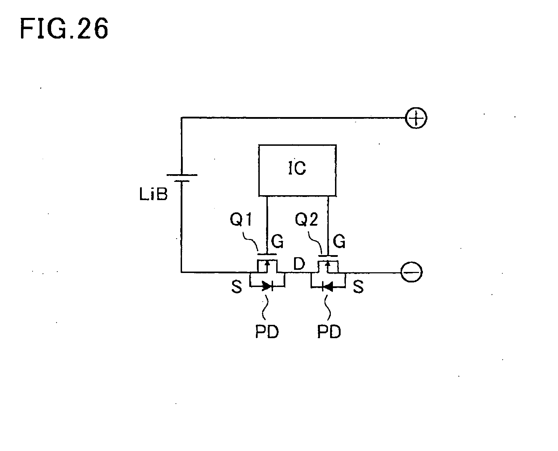

Fig. 26 is a circuit diagram showing an example of the protection circuit device.

Two MOSFETs Q1 and Q2 are connected in series with a secondary battery LiB. The MOSFETs Q1 and Q2 have a drain D connected in common and, each of the MOSFETs has a source S disposed on one end thereof. Each of gates G is connected to a control circuit IC. The control circuit IC performs on/off control of the two MOSFETs Q1 and Q2 while detecting a voltage of the secondary battery LiB, and protects the secondary battery LiB from overcharge, overdischarge or load short-circuiting. This technology is described for instance in Japanese Patent Application Publication No. 2002-118258.

For example, the control circuit IC detects the voltage of the battery, and switches the MOSFET Q2 to an off state when the detected voltage is higher than a maximum set voltage. Thus, overcharge of the secondary battery LiB is prevented. Moreover, the control circuit IC switches the MOSFET Q1 to an off state when the detected voltage is lower than a minimum set voltage. Thus, overdischarge of the secondary battery LiB is prevented.

As shown in Figs. 25A and 25B, in the conventional MOSFET, both of the body region 49 and the source region 48 are connected to the source electrode 51, and potentials thereof are fixed. When the MOSFET is used for a bidirectional switching element, two MOSFETs are connected in series, and potentials of the respective source electrodes 51 are switched. Thus, current paths are formed in two directions.

This is because, as shown in Fig. 26, each of the MOSFETs includes a parasitic diode PD. Specifically, in the MOSFET having fixed potentials of the body region 49 (that is, a back gate region) and the source region 48, a forward operation of the parasitic diode PD in the off state is inevitable.

Therefore, when the MOSFET is off, it is required to control so as not to allow formation of an unwanted current path by the parasitic diode PD.

Thus, as shown in Fig. 26, the two MOSFETs having the same number of cells and the same chip size are connected in series, and the MOSFETs Q1 and Q2 and the parasitic diodes PD thereof are controlled by the control circuit. Thus, desired current paths are formed.

Incidentally, in order to reduce an on-resistance in the MOSFET, a certain number of cells and a certain chip size are required. Meanwhile, the secondary battery has become popular as a battery for a portable terminal. Accordingly, along with miniaturization of the portable terminal, miniaturization of a protection circuit thereof has been also increasingly demanded. However, the above-described protection circuit having the two MOSFETs Q1 and Q2 connected in series has its limitations, which makes it hard to meet the demand. It is thus an object of this invention to provide a semiconductor device and protection circuit that lessens this drawback. The solution according to the invention lies in the features of the independent claims and preferably in those of the dependent claim.

### SUMMARY OF THE INVENTION

The invention provides an insulated gate semiconductor device that includes a drain region having a semiconductor substrate of a first general conductivity type and a semiconductor layer of the first general conductivity type disposed on the substrate, a channel layer of a second general conductivity type disposed on the semiconductor layer, and a plurality of trenches formed in the channel layer and reaching the drain region through the channel layer. The trenches are elongated in a first direction within a primary plane of the substrate. The device also includes a gate electrode disposed in each of the trenches, and a plurality of source regions of the first general conductivity type formed in the channel layer between the trenches. The source regions are aligned in a second direction within the primary plane of the substrate. The device further includes a plurality of body regions of the second general conductivity type formed in the channel layer between the trenches. The body regions are aligned in the second direction, and each of the body regions is disposed adjacent a corresponding source region. In addition, the device includes a plurality of first electrode layers disposed on the source regions so that each of the first electrode layers connects corresponding source regions aligned in the second directions, and a plurality of second electrode layers disposed on the body regions so that each of the second electrode layers connects corresponding body regions aligned in the second direction.

The invention also provides a protection circuit for a secondary battery. The circuit includes a switching device having a drain region, a drain electrode attached to the drain region, a channel layer disposed on the drain region, a trench formed in the channel layer and extending horizontally in a first direction, a gate electrode disposed in the trench, a source region formed in the channel layer adjacent the trench, a body region formed in the channel layer adjacent the trench, a first electrode in contact with the source region and extending horizontally in a second direction, and a second electrode in contact with the body region and extending horizontally in the second direction. The switching device is connected with the secondary battery. The circuit also includes a control circuit connected with the switching device and configured to apply voltages separately to the first electrode and the second electrode.

The invention further provides a method of manufacturing an insulated gate semiconductor device. The method includes providing a semiconductor substrate of a first general conductivity type, forming a channel layer of a second general conductivity type on the substrate, forming a plurality of trenches in the channel layer so as to extend in a first direction within a primary plane of the substrate, forming a gate electrode in each of the trenches, forming a plurality of source regions of the first general conductivity type in the channel layer between the trenches so as to be aligned in a second direction within the primary plane of the substrate, forming a plurality of body regions of the second general conductivity type in the channel layer between the trenches so as to be aligned in the second direction, forming a plurality of first electrode layers on the source regions so that each of the first electrode layers connects corresponding source regions aligned in the second directions, and forming a plurality of second electrode layers on the body regions so that each of the second electrode layers connects corresponding body regions aligned in the second direction.

### BRIEF DESCRIPTION OF THE DRAWINGS

Figs. 1A and 1B are perspective views showing an insulated gate semiconductor device of a first embodiment of the invention.
Figs. 2A and 2B are cross-sectional views showing the insulated gate semiconductor device of the first embodiment of the invention.
Fig. 3 is a circuit diagram showing the insulated gate semiconductor device of the first embodiment of the invention.
Fig. 4 is a schematic circuit diagram showing the insulated gate semiconductor device of the first embodiment of the invention.
Fig. 5 is a schematic circuit diagram showing the insulated gate semiconductor device of the first embodiment of the invention.
Figs. 6, 7, 8, 9A, 9B, 10A, 10B, 11A, 11B and 11C are a cross-sectional view showing successive process steps of the method of manufacturing the insulated gate semiconductor device of the first embodiment of the invention.
Fig. 12A is a perspective view, and Figs. 12B and 12C are cross-sectional views showing an insulated gate semiconductor device of a second embodiment of the invention.
Figs. 13A, 13B, 14A, 14B, 15A, 15B and 15C are cross-sectional views showing a method of manufacturing the insulated gate semiconductor device of the second embodiment of the invention.
Figs. 16A and 16B are perspective views showing an insulated gate semiconductor device as a modification to the first embodiment of the invention.
Figs. 17A and 17B are cross-sectional views showing the insulated gate semiconductor device of Figs. 16A and 16B.
Figs. 18 and 19 are schematic circuit diagrams showing the insulated gate semiconductor device of Figs. 16A and 16B, and Fig 20 shows a comparative example.
Figs. 21A and 21B show the electric filed as a function of the depth of the impurity region.
Fig. 22 shows a process step to form the low concentration impurity region of the device of Figs. 16A and 16B.
Fig. 23A is a perspective view showing an insulated gate semiconductor device as a modification to the second embodiment of the invention, and Figs. 23B and 23C are cross-sectional views showing the insulated gate semiconductor device of the modification.
Fig. 24 shows a process step to form the low concentration impurity region of the device of Fig. 23A.
Fig. 25A is a plan view and Fig. 25B is a cross-sectional view showing a conventional insulated gate semiconductor device.
Fig. 26 is a circuit diagram showing the conventional insulated gate semiconductor device.

### DETAILED DESCRIPTION OF THE INVENTION

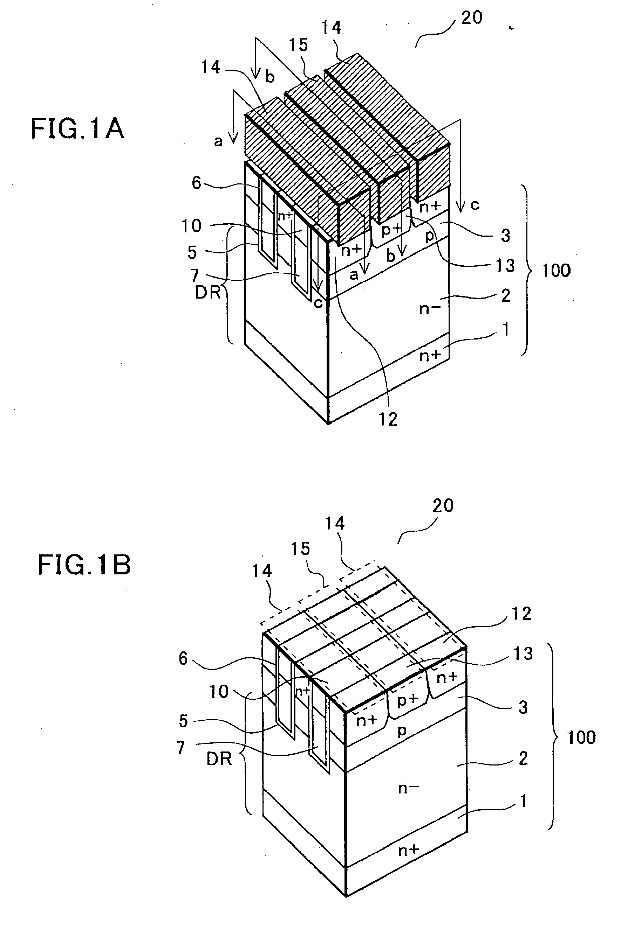

With reference to Figs. 1 to 15, embodiments of the invention are described by taking an n-channel MOSFET having a trench structure as an example.

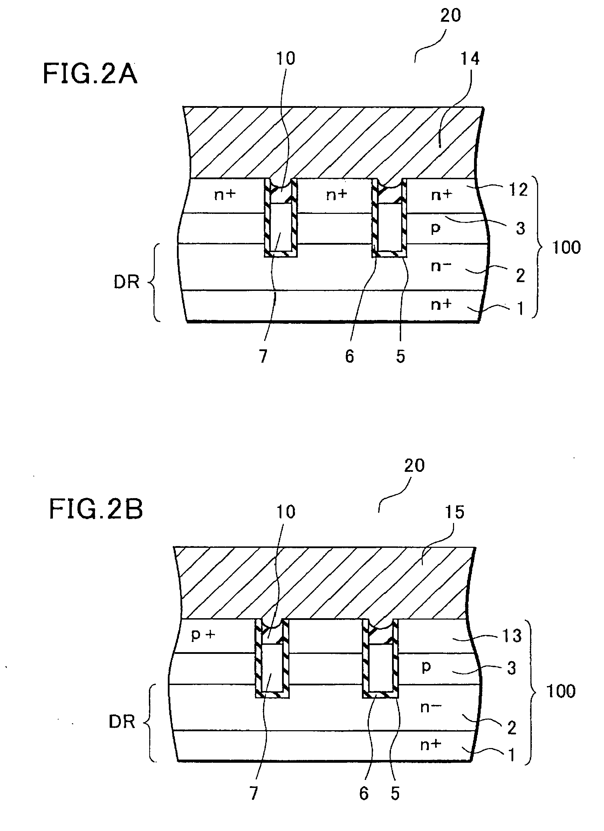

First, with reference to Figs. 1 to 11, a first embodiment is described. Figs. 1A and 1B are perspective views showing a MOSFET of the first embodiment. Fig. 1A shows the structure of the first embodiment with first and second electrode layers, and Fig. 1B shows the structure of the embodiment with the first and second electrode layers removed as indicated by broken lines. Moreover, Figs. 2A and 2B are cross-sectional views of the MOSFET. Fig. 2A is a cross-sectional view along line a-a in Fig. 1A, and Fig. 2B is a cross-sectional view along line b-b in Fig. 1A.

The MOSFET 20 includes a semiconductor substrate 1, a semiconductor layer 2, a channel layer 3, a trench 5, a gate insulating film 6, a gate electrode 7, a source region 12, a body region 13, an interlayer insulating film 10, a first electrode layer 14, a second electrode layer 15 and a drain electrode 16.

In a substrate 100, a drain region DR is provided by laminating the n- type epitaxial layer 2 on the n+ type silicon semiconductor substrate 1, and the like. On the n- type epitaxial layer 2, the channel layer 3 that is a p type impurity region is provided.
The trench 5 is provided to have a depth that reaches the n-type epitaxial layer 2 while penetrating the channel layer 3. Moreover, in a surface of the n- type epitaxial layer 2 (the channel layer 3), the trenches are formed in a stripe pattern extended in a first direction. The source region 12 and the body region 13 are alternately placed and extended in a second direction which is perpendicular to the extending direction of the trench 5 (see Fig. 1B).

With reference to Figs. 2A and 2B, an inner wall of the trench 5 is covered with the gate insulating film 6 having a thickness according to a drive voltage. The gate electrode 7 is obtained by burying polysilicon in the trench 5, the polysilicon having impurities introduced therein for achieving a low resistance. The gate electrode 7 is provided so as to have its upper part positioned lower than an opening of the trench 5, that is, the surface of the channel layer 3 by about several thousand Å.

The source region 12 is formed by diffusing high-concentration n type impurities so as to be adjacent to the trench 5. In Fig. 2A, this high concentration impurity region is referred to as "n⁺." The source region 12 is provided in the surface of the channel layer 3 around the opening of the trench 5. Moreover, a part of the source region 12 is expanded in a depth direction of the trench 5 along a sidewall of the trench 5 and is provided to have a depth that reaches the gate electrode 7. In the cross section shown in Fig. 2A, only the source region 12 is placed between the trenches 5 adjacent to each other. Moreover, the source regions 12 adjacent to each other along an extending direction of the trench 5 (the first direction) are placed at a predetermined interval, and the body region 13 is placed therebetween. Specifically, the one source region 12 is positioned adjacent to the two body regions 13 placed along the same sidewall of the trench 5, as shown in Fig. 1B.

The body region 13 is formed by diffusing high-concentration p type impurities so as to be adjacent to the trench 5. The body region 13 is provided in the surface of the channel layer 3 around the opening of the trench 5. In the cross section shown in Fig. 2B, only the body region 13 is placed between the trenches 5 adjacent to each other. Moreover, the body regions 13 adjacent to each other along the extending direction of the trench 5 (the first direction) are placed at a predetermined interval, and the source region 12 is placed therebetween. Specifically, the one body region 13 is positioned adjacent to the two source regions 12 placed along the same sidewall of the trench 5, as shown in Fig. 1B. In other words, although the two source regions 12 and the one body region 13 are placed in Figs. 1A and 1B, a plurality of the source regions 12 and the body regions 13 are alternately placed.

The interlayer insulating film 10 is entirely buried in the trench 5. An upper end (surface) of the gate electrode 7 is positioned lower than the surface of the channel layer 3 by about several thousand Å. The interlayer insulating film 10 is entirely buried in the trench 5 between the upper end of the gate electrode 7 and the surface of the channel layer 3, and has no portion protruding from the surface of the substrate, as shown in Figs. 2A and 2B.

The first electrode layer 14 is provided so as to be approximately flat on the gate electrode 7 and the interlayer insulating film 10 and is contact with the source region 12. Since the interlayer insulating film 10 is buried in the trench 5, the first electrode layer 14 is provided so as to be approximately flat without much unevenness on the interlayer insulating film 10. The first electrode layer 14 is provided on the source region 12 and extended in the second direction (the direction perpendicular to the extending direction of the trench 5) over the surface of the n- type epitaxial layer 2 (the channel layer 3).

The second electrode layer 15 is provided so as to be approximately flat on the gate electrode 7 and the interlayer insulating film 10 and is in contact with the body region 13. Since the interlayer insulating film 10 is buried in the trench 5, the second electrode layer 15 is provided so as to be approximately flat without much unevenness on the interlayer insulating film 10. The second electrode layer 15 is provided on the body region 13 and extended in the second direction over the surface of the n- type epitaxial layer 2 (the channel layer 3).

The first and second electrode layers 14 and 15 are alternately placed. The first and second electrode layers 14 and 15 are provided at a predetermined interval and are insulated from each other by a passivation film (not shown) which is provided thereon. Moreover, on a rear surface of the n+ type semiconductor substrate 1, the drain electrode (not shown) is formed by metal deposition or the like.

By burying the interlayer insulating film 10 in the trench 5, the first electrode layer 14 approximately evenly comes into contact with the source region 12 and the second electrode layer 15 approximately evenly comes into contact with the body region 13 above the gate electrode 7. The first and second electrode layers 14 and 15 are formed in a stripe pattern at predetermined intervals therebetween, respectively. Thus, contact failures with the source region 12 and the body region 13 can be reduced, respectively. Moreover, it is possible to prevent generation of voids due to deterioration of step coverage and cracks in wire bonding. Thus, the reliability is improved.

According to this embodiment, in the MOSFET 20 which forms one chip, a potential applied to the first electrode layer 14 and a potential applied to the second electrode layer 15 can be individually controlled. Specifically, the potentials between the source region 12 and the body region (hereinafter referred to as a back gate region) 13 can be individually controlled.

Specifically, by use of the MOSFET 20 of this embodiment, a bidirectional switching element which switches between current paths in two directions can be realized with one chip. The bidirectional switching element is described below.

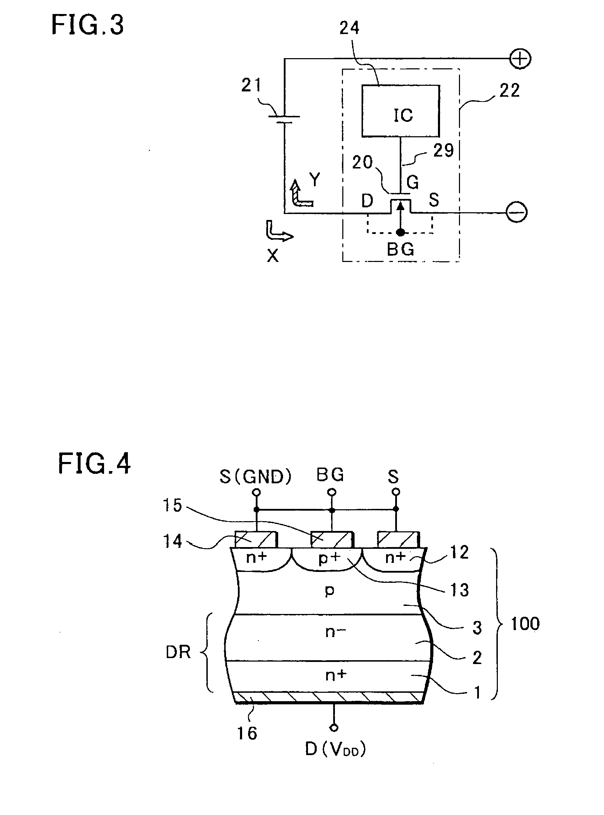

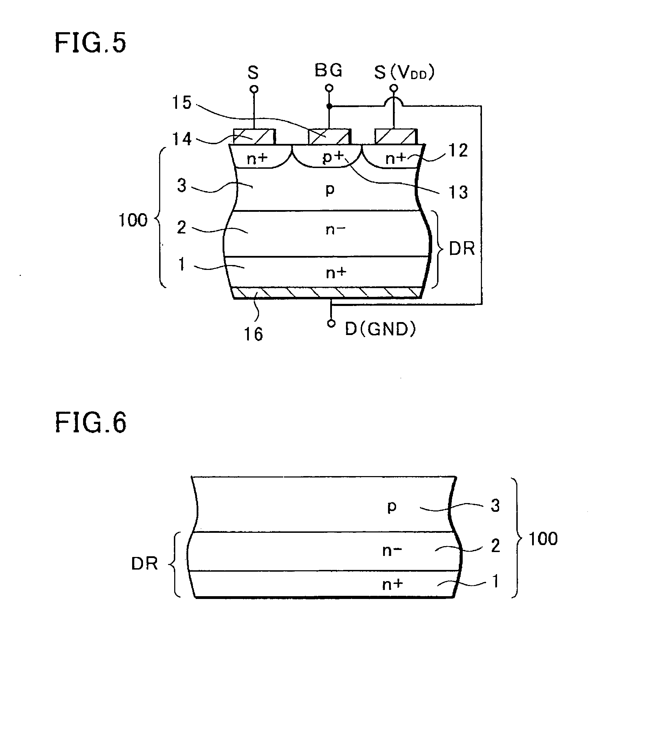

Figs. 3 to 5 show an example where the MOSFET 20 shown in Figs. 1A and 1B is used as the bidirectional switching element. Fig. 3 is a circuit diagram showing a protection circuit of a secondary battery. Figs. 4 and 5 are schematic diagrams showing the device when the MOSFET 20 is in an off state.

As shown in Fig. 3, a protection circuit 22 includes one MOSFET 20 that is a switching element and a control circuit 24.

The MOSFET 20 is connected in series with a secondary battery 21 and performs charge and discharge of the secondary battery 21. In the MOSFET 20, a bidirectional current path is formed.

The control circuit 24 includes a one control terminal 29 which applies a control signal to a gate G of the MOSFET 20.

In charge and discharge operations, the control circuit 24 switches the MOSFET 20 to an on state and allows currents to flow in a charge direction of the secondary battery 21 and in the discharge direction according to potentials of source S and drain D of the MOSFET 20. Moreover, for example, when the charge and discharge operations are off or at the time of switching between charge and discharge, the MOSFET 20 is set in the off state. In this event, a parasitic diode included in the MOSFET 20 forms a current path opposite to a desired path. However, in this embodiment, the opposite current path is blocked. Specifically, when the MOSFET 20 is off, a terminal having a lower potential, either the source S or the drain D, is connected to a back gate BG. Thus, the current path formed by the parasitic diode is blocked.

To be more specific, in the case of charge, the drain D is set to a power supply potential VDD and the source S is set to a ground potential GND. Thereafter, a predetermined potential is applied to the gate G to set the MOSFET 20 in the on state. Thus, a current path is formed in the charge direction (the arrow X).

Next, in the case of discharge, the drain D is set to the ground potential GND and the source S is set to the power supply potential VDD. Thereafter, the predetermined potential is applied to the gate G to set the MOSFET 20 in the on state. Thus, a current path is formed in the discharge direction (the arrow Y).

With reference to Figs. 4 and 5, the off state of the MOSFET 20 is described. Fig. 4 shows the device when the MOSFET 20 is turned off right after the charging. Fig. 5 shows the device when the MOSFET 20 is turned off right after the discharging. Note that Figs. 4 and 5 are schematic diagrams corresponding to a cross section along the line c-c in Fig. 1A.

As shown in Fig. 4, when the MOSFET 20 is turned off in a charge state, such as at the time of switching from charge to discharge and at the time of overcharge, the source S and the back gate BG are short-circuited by the control circuit 24.

In this case, the power supply potential VDD is applied to the drain electrode 16 (the drain D), and the second electrode layer 15 (the back gate BG) and the first electrode layer 14 (the source S) are short-circuited and grounded. Since the drain D is set to the power supply potential VDD, the parasitic diode formed of the p type channel layer 3 and the n (n+/n-) type substrate 100 is set in a reverse bias state. Specifically, since a current path formed by the parasitic diode is blocked, a reverse current can be prevented. Moreover, the drain D has a potential higher than that of the back gate BG. Thus, the parasitic bipolar action never occurs.

Meanwhile, as shown in Fig. 5, when the MOSFET 20 is turned off in a discharge state such as at the time of switching from discharge to charge and at the time of overdischarge, the drain D and the back gate BG are short-circuited by the control circuit 24.

In this case, the drain electrode 16 (the drain D) and the second electrode layer 15 (the back gate BG) are short-circuited and grounded. Thus, the power supply potential VDD is applied to the first electrode layer 14 (the source S).
Since the source S is set to the power supply potential VDD, the parasitic diode is set in a reverse bias state. In addition, since a current path formed by the parasitic diode is blocked, a reverse current can be prevented. Moreover, the drain D and the back gate BG have the same potential. Thus, the parasitic bipolar action never occurs.

As described above, in this embodiment, the first electrode layer 14 connected to the source region 12 and the second electrode layer 15 connected to the back gate region (the body region) 13 are individually formed. Therefore, bidirectional switching can be controlled by applying predetermined potentials to the first and second electrode layers 14 and 15, respectively, and using the one MOSFET 20.

Next, with reference to Figs. 6 to 11, the descriptions are given of a method of manufacturing an insulated gate semiconductor device according to the first embodiment by taking an n-channel MOSFET having a trench structure as an example.

Fig. 6 shows the first step of the manufacturing method of the first embodiment. A substrate 100 is prepared by laminating an n- type epitaxial layer 2 on an n+ type silicon semiconductor substrate 1, and the like, and a drain region DR is formed. After an oxide film (not shown) is formed on a surface of the substrate 100, the surface of the substrate 100 is exposed by etching the oxide film in a portion of a channel layer to be formed. By using the oxide film as a mask, boron (B) or the like is implanted into the entire surface, for example, at an acceleration energy of about 50 KeV by a dose of 1.0×10¹² cm⁻² to 1.0×10¹³ cm⁻². Thereafter, boron is diffused to form a p type channel layer 3 having a thickness of about 1.5 µm.

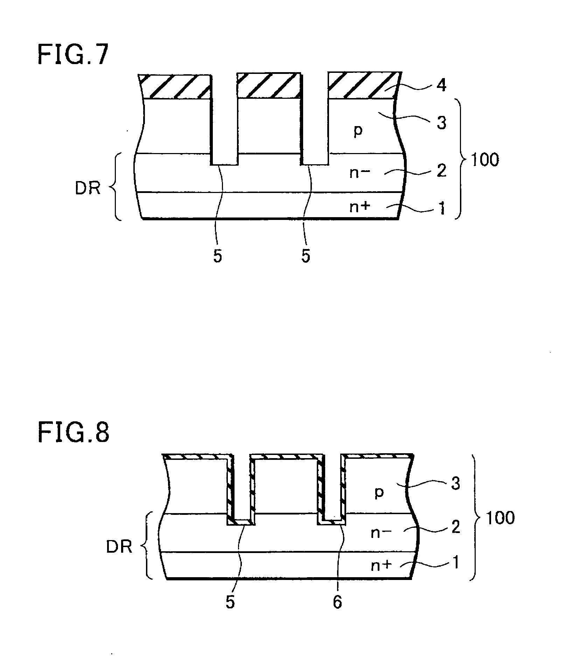

Fig. 7 shows the second step of the method of the first embodiment. First, by use of a CVD method, a CVD oxide film 4 made of NSG (Non-doped Silicate Glass) is formed to have a thickness of 3000 Å on the entire surface. Thereafter, by using a mask made of a resist film, the CVD oxide film 4 is dry-etched and partially removed. Thus, the channel layer 3 is exposed. Subsequently, the resist film is removed. Thereafter, by use of the CVD oxide film 4 as a mask, the exposed substrate 100 is anisotropically dry-etched by using CF and HBr gas. Thus, a trench 5 is formed, which has a depth of about 2.0 µm that reaches the n- type epitaxial layer 2 while penetrating the channel layer 3. A width of the trench 5 is set to about 0.5 µm.

Over the surface of the channel layer 3, the trenches 5 are patterned into stripes extended in the first direction, as shown in Fig. 1B.

Fig. 8 shows the third step of the method of the first embodiment. By dummy oxidation, an oxide film (not shown) is formed on an inner wall of the trench 5 and on the surface of the channel layer 3. Thus, etching damage in dry etching is removed. Thereafter, the oxide film described above and the CVD oxide film 4 used as the mask for trench etching are removed by etching. Subsequently, a gate oxide film 6 is formed. Specifically, by thermally oxidizing the entire surface, the gate oxide film 6 is formed to have a thickness of, for example, about 300 Å to 700 Å according to a drive voltage.

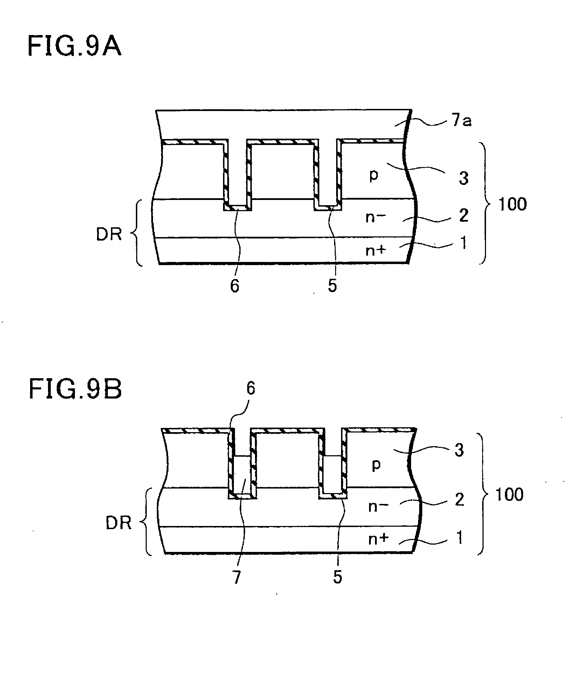

9A and 9B show the fourth step of the method of the first embodiment. A polysilicon layer 7a having a high conductivity is provided by depositing a polysilicon layer including high-concentration impurities on the entire surface or by attaching a non-doped polysilicon layer to the entire surface and depositing and diffusing high-concentration impurities (Fig. 9A). Thereafter, the entire surface is dry-etched without a mask. In this event, the surface is over-etched so as to position an upper part of the polysilicon layer 7a lower than an opening of the trench 5. Thus, a gate electrode 7 buried in the trench 5 is provided. An upper part of the gate electrode 7 is positioned lower than the opening of the trench 5 by about 8000 Å, and the gate oxide film 6 on a sidewall of the trench 5 around the opening of the trench 5 is exposed (Fig. 9B).

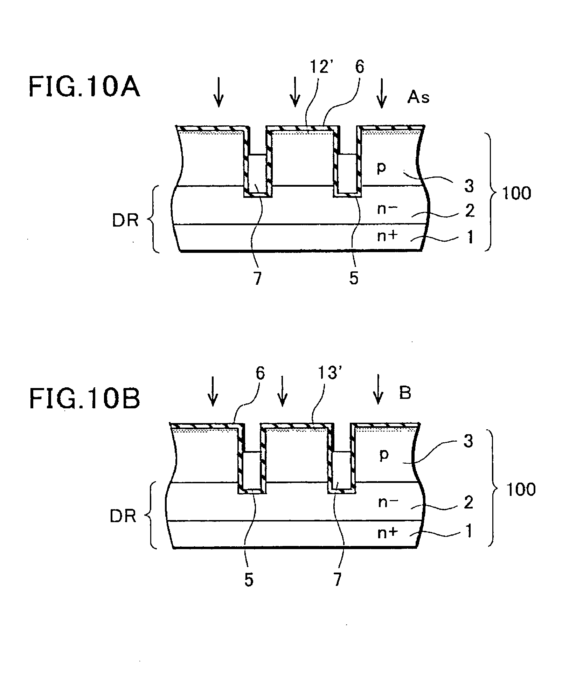

Figs. 10A-11C show the fifth step of the method of the first embodiment. A stripe-shaped mask (not shown) is provided so as to expose the surface of the channel layer 3 in a formation region of a source region. For example, arsenic (As) is ion-implanted into the entire surface by a dose of about 5.0×10¹⁵ cm⁻². Thus, the surface of the channel layer 3 is doped with n+ type impurities to form an n type impurity region 12'. And the mask is removed. Note that, here, a cross-sectional view corresponding to Fig. 2A is shown (Fig. 10A).

Next, a stripe-shaped mask (not shown) is provided so as to expose the surface of the channel layer 3 in a region where a body region is to be formed. Note that, here, a cross-sectional view corresponding to Fig. 2B is shown.

For example, boron is ion-implanted into the entire surface by a dose of about 5.0×10¹⁴ cm⁻². Thus, a p type impurity region 13' is formed in the exposed surface of the channel layer 3. And the mask is removed (Fig. 10B).

After a TEOS(Tetraethylorthosilicate) film (not shown) having a thickness of about 2000 Å is laminated on the entire surface, a BPSG (Boron Phosphorus Silicate Glass) layer 10a is deposited in a thickness of about 6000 Å by use of the CVD method of the first embodiment. Thereafter, a SOG (Spin On Glass) layer 10b is formed.

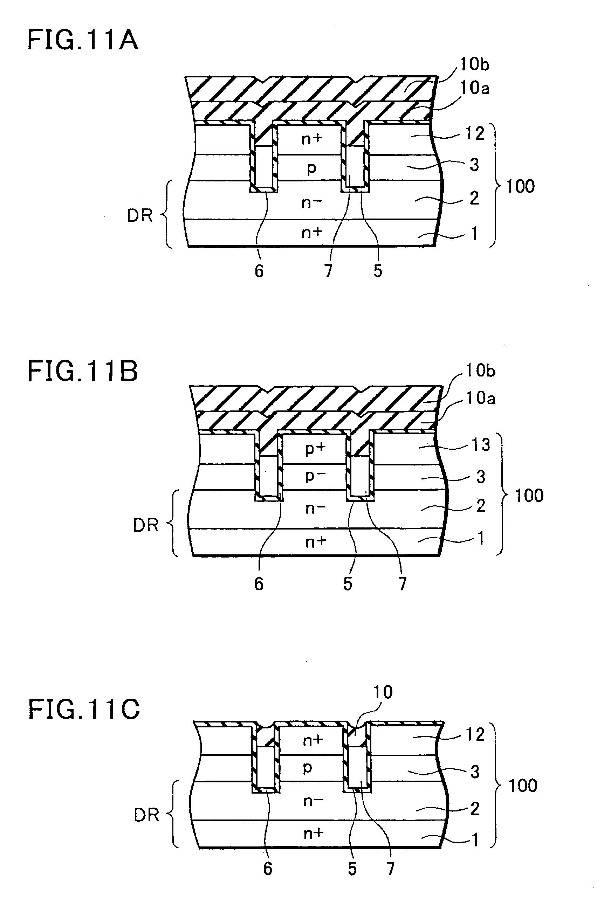

Subsequently, heat treatment for planarization is performed. Thus, the n type impurity region 12' and the p type impurity region 13' are diffused. Accordingly, in the cross section corresponding to Fig. 2A, an n type source region 12 is formed in the surface of the channel layer 3. The source region 12 is adjacent to the gate electrode 7 with the gate insulating film 6 interposed therebetween (Fig. 11A).

Similarly, also in the cross section corresponding to Fig. 2B, a p type body region 13 is formed in the surface of the channel layer 3. The body region 13 is adjacent to the gate electrode 7 with the gate insulating film 6 interposed therebetween (Fig. 11B).

The body region 13 and the source region 12 are provided in a second direction perpendicular to the first direction in which the trench 5 is extended.

The body region 13 and the source region 12 are alternately placed along the same sidewall of the trench 5. Moreover, in the second direction , only one of the source region 12 and the body region 13 is placed between the trenches 5 adjacent to each other (see Fig. 1B).

Thereafter, the entire surface is etched back to expose the surface of the channel layer 3. Thus, an interlayer insulating film 10 buried in the trench 5 is formed. Here, in etching back, it is desirable to somewhat over-etch the surface in order to prevent the films from remaining. To be more specific, by use of end point detection, the interlayer insulating film 10 is etched until silicon in the surface of the channel layer 3 is exposed. Thereafter, the interlayer insulating film 10 is further over-etched. Thus, the interlayer insulating film 10 is completely buried in the trench 5 on the gate electrode 7. Moreover, since there is no protrusion on the surface of the substrate 100, the surface of the substrate 100 after formation of the interlayer insulating film 10 is set to be approximately flat.

As described above, in this embodiment, the interlayer insulating film 10 can be formed without providing a mask. Although, here, the cross section corresponding to Fig. 2A is shown, the interlayer insulating film 10 is similarly buried in the trench 5 also in the cross section corresponding to Fig. 2B (Fig. 11C).

In the conventional case, as shown in Figs. 25A and 25B, the source region 48 and the body region 49 are formed parallel to the trench 44. However, in the steps of forming the source region 48, the body region 49 and the interlayer insulating film 50, one mask is required, respectively. Therefore, for alignment between the trench 44 and the source region 48 and between the trench 44 and the body region 49, it is required to take account of misalignment for three masks to be used.

However, in this embodiment, the source region 12 and the body region 13 are formed so as to be extended in the direction perpendicular to the extending direction of the trench 5. Therefore, although two masks are required for the steps of forming the source region 12 and the body region 13, it is only necessary to take account of misalignment for one mask.

Specifically, compared with the conventional case, the distance between trenches, which is secured to take account of mask misalignment, can be reduced. Therefore, the operating region where cells are arranged can be increased. Thus, if the same chip size is adopted, an on-resistance can be reduced, and, if the same number of cells is used, the chip size can be reduced.

Note that the order in which the source region 12 and the body region 13 are formed may be reversed.

Fig. 2A shows the sixth step of the method of the first embodiment. Aluminum is attached to the entire surface by use of a sputtering apparatus and is patterned into a desired shape. Thus, a first electrode layer 14 is formed, which is in contact with the source region 12. The first electrode layer 14 is provided on the source region 12 and is extended in the second direction perpendicular to the extending direction of the trench 5 (the first direction) on the surface of the channel layer 3.

In this embodiment, the interlayer insulating film 10 is buried on the gate electrode 7, and the first electrode layer 14, which is approximately flat, can be formed. Thus, the step coverage can be improved.

Fig. 2B shows the seventh step of the method of the first embodiment. Aluminum is attached to the entire surface by use of the sputtering apparatus and is patterned into a desired shape. Thus, a second electrode layer 15 is formed, which is in contact with the body region 13. The second electrode layer 15 is provided on the body region 13 and is extended in the second direction on the surface of the channel layer 3. The second electrode layer 15 is placed parallel to the first electrode layer 14 with a space therebetween.

In this embodiment, the interlayer insulating film 10 is buried on the gate electrode 7, and the second electrode layer 15, which is approximately flat, can be formed. Thus, the step coverage can be improved.

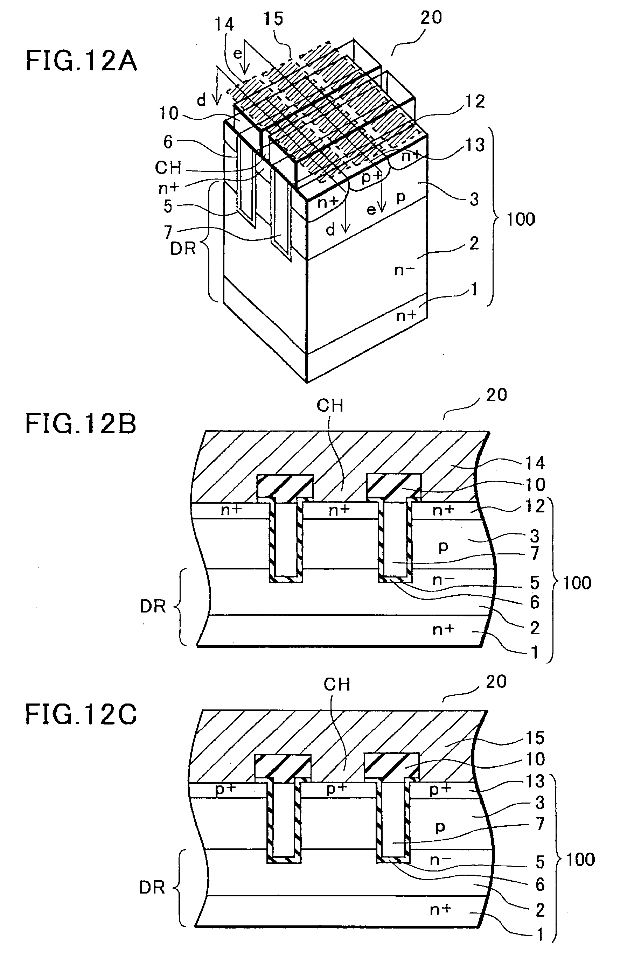

With reference to Figs. 12 to 15, a second embodiment of the invention is described.

Figs. 12A to 12C show a structure of the second embodiment. Fig. 12A is a perspective view, Fig. 12B is a cross-sectional view along the line d-d in Fig. 12A, and Fig. 12C is a cross-sectional view along the line e-e in Fig. 12A.

In the structure of the second embodiment, an interlayer insulating film 10 is not buried in a trench 5 but protrudes from a surface of a channel layer 3.

Specifically, a gate electrode 7 is buried up to the vicinity of an opening of the trench 5, and the interlayer insulating film 10 is provided on a substrate 100 so as to cover the gate electrode 7 and a part of a source region 12 or a body region 13 which is provided around the trench 5.

A first and second electrode layers 14 and 15 are provided so as to cover the interlayer insulating film 10 protruding from the surface of the channel layer 3 and are in contact with the source region 12 or the body region 13 which is exposed between the interlayer insulating films 10. In Fig. 12A, the regions where the first and second electrode layers 14 and 15 are placed are indicated by the broken lines in a planar pattern. However, the first and second electrode layers 14 and 15 actually cover the surface of a substrate 100 and the interlayer insulating film 10 as shown in Figs. 12B and 12C. Since other constituent components are the same as those of the first embodiment, the descriptions of those components are omitted.

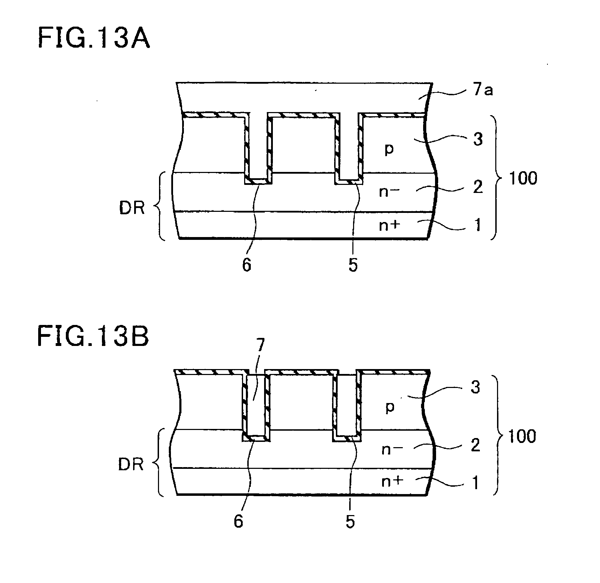

With reference to Figs. 13 to 15, a method of manufacturing a MOSFET according to the second embodiment is described by taking an n-channel MOSFET as an example.

The first to third steps are the same as those of the first embodiment and their descriptions are omitted.

Figs. 13A and 13B show the fourth step of the method of the second embodiment. A polysilicon layer 7a having a high conductivity is provided by depositing a polysilicon layer including high-concentration impurities on the entire surface or by attaching a non-doped polysilicon layer to the entire surface and depositing and diffusing high-concentration impurities (Fig. 13A). Thereafter, the entire surface is dry-etched without a mask. Thus, a gate electrode 7 buried in a trench 5 is provided. A surface of the gate electrode 7 is positioned around the opening of the trench 5 (Fig. 13B).

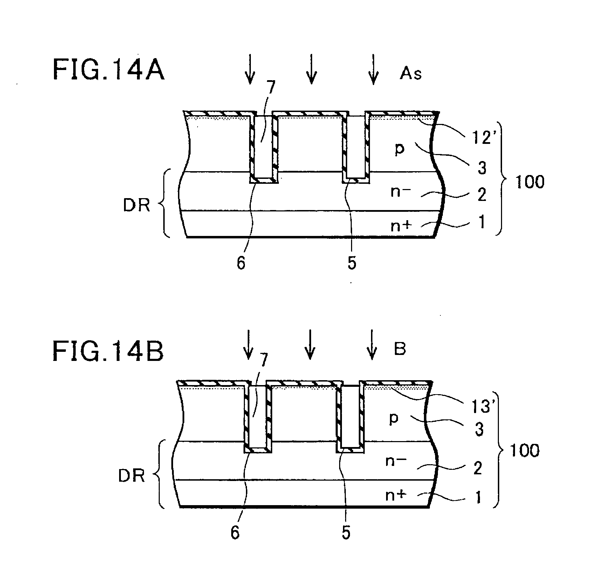

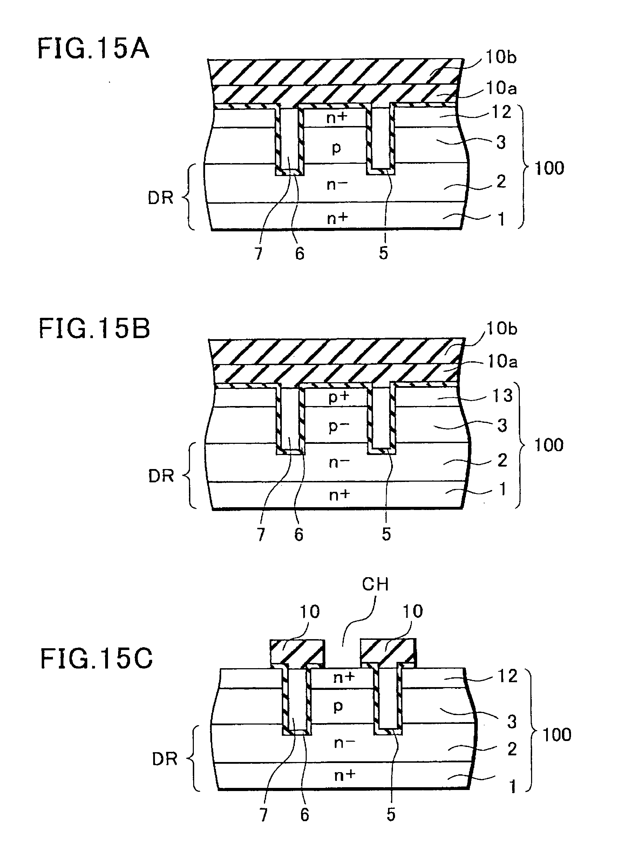

Figs. 14 and 15 show the fifth step of the method of the second embodiment. A stripe-shaped mask is provided so as to expose a formation region of a source region. Thereafter, arsenic, for example, is ion-implanted into the entire surface by a dose of about 5.0×10¹⁵ cm⁻². Thus, the surface of a channel layer 3 is doped with n+ type impurities to form a one conductivity type impurity region 12'. The mask is removed. Note that, here, a cross-sectional view corresponding to Fig. 12B is shown (Fig. 14A).

Next, a stripe-shaped mask (not shown) is provided so as to expose the surface of the channel layer 3 in a region where a body region is to be formed. Note that, here, a cross-sectional view corresponding to Fig. 12C is shown.

For example, boron is ion-implanted into the entire surface by a dose of about 5.0×10¹⁴ cm⁻². Thus, an opposite conductivity type impurity region 13' is formed in the exposed surface of the channel layer 3. The mask is removed (Fig. 14B).

After a TEOS film (not shown) having a thickness of about 2000 Å is laminated on the entire surface, a BPSG (Boron Phosphorus Silicate Glass) layer 10a is deposited in a thickness of about 6000 Å by use of the CVD method. Thereafter, a SOG (Spin On Glass) layer 10b is formed. Subsequently, heat treatment (about 900 °C) for planarization is performed.

By the heat treatment, impurities in the one conductivity type impurity region 12' are diffused, as shown in Fig. 15A, and an n type source region 12 is formed in the surface of the channel layer 3. At the same time, as shown in Fig. 15B, impurities in the opposite conductivity type impurity region 13' are diffused, and a p type body region 13 is formed in the surface of the channel layer 3.

The source region 12 and the body region 13 are adjacent to the gate electrode 7 with a gate insulating film 6 interposed therebetween.

The body region 13 and the source region 12 are alternately placed along the same sidewall of the trench 5. Moreover, in a second direction perpendicular to a first direction in which the trench 5 is extended, only one of the source region 12 and the body region 13 is placed between the trenches 5 adjacent to each other (see Fig. 12A).

Thereafter, a new resist mask (not shown) is provided, and the BPSG film 10a and the SOG film 10b are etched. Thus, a contact hole CH and an interlayer insulating film 10 are formed. The interlayer insulating film 10 covers the gate electrode 7 and a part of the source region 12 adjacent to the trench 5 (Fig. 15C). Note that, although not shown in the drawing, the interlayer insulating film 10 similarly covers a part of the body region 13.

Since subsequent steps are the same as those of the first embodiment, the description thereof are omitted.

Note that, in this embodiment, the description has been given by taking the n-channel MOSFET as an example. However, the embodiment of the invention can also be applied to a p-channel MOSFET having a conductivity type reversed. Moreover, the embodiment can also be applied to an IGBT (Insulated Gate Bipolar Transistor) in which a semiconductor layer having a conductivity type opposite to that of a substrate 100 is provided below the substrate 100 and a bipolar transistor and a power MOSFET are monolithically combined within one chip.

There are a few modifications to the first and second embodiments of the invention.

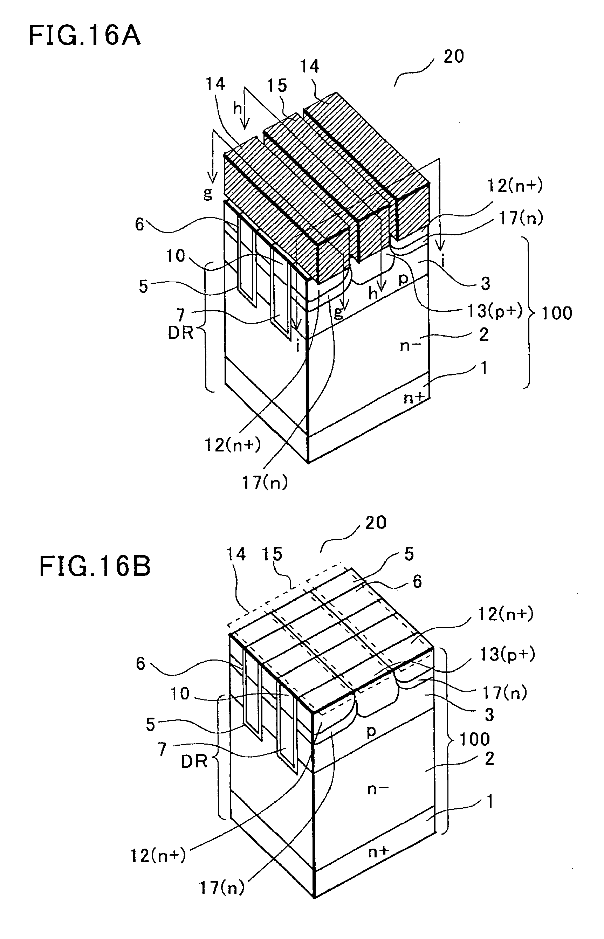

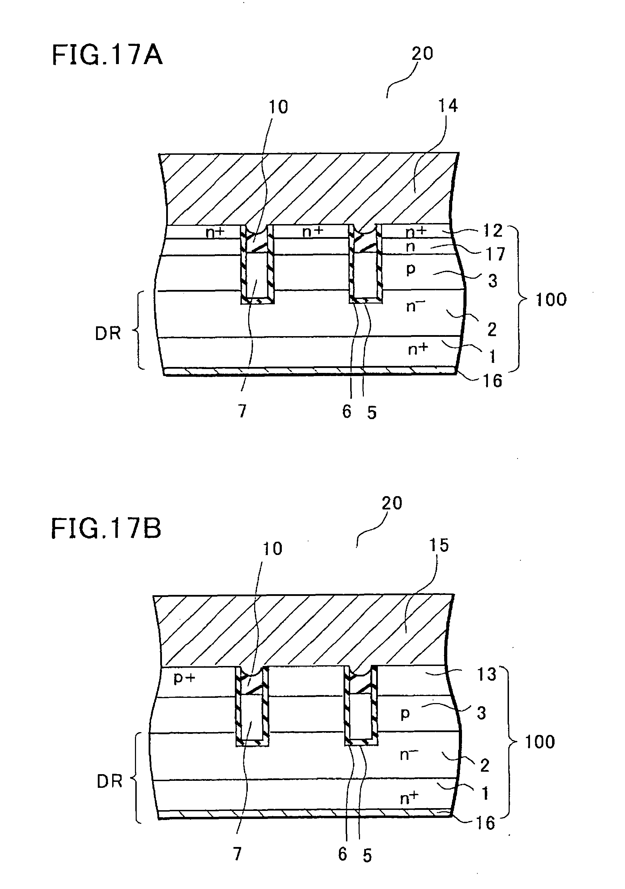

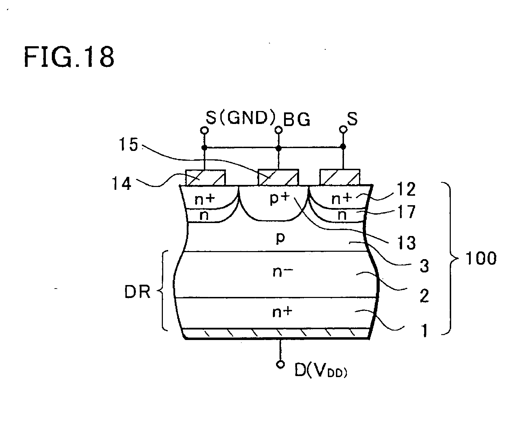

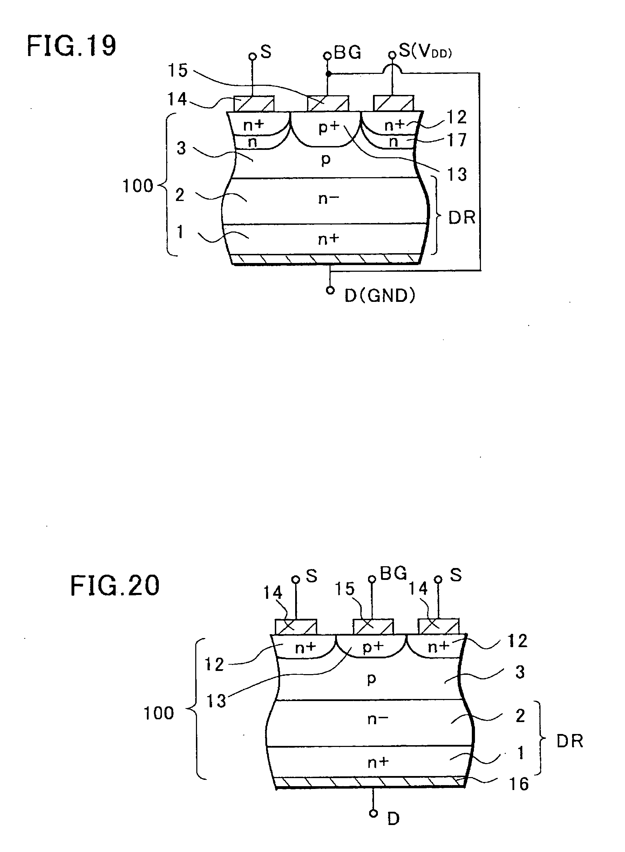

Figs. 16A and 16B show one modification to the fist embodiment. The modification over the structure shown in Figs. 1A and 1B is that a low concentration impurity region 17, referred to as "n" in the drawings, is provided between the high concentration impurity region 12, referred to as "n⁺" in the drawings, and the channel layer 3. The impurity concentration of the low concentration impurity region n 17 is about 1×10¹⁶ cm⁻³ to 1×10¹⁸ cm⁻³. On the other hand, the impurity concentration of the high concentration impurity region 12 is about 5×10¹⁸ cm⁻³ to 5×10²⁰ cm⁻³. Figs. 17A and 17B show the cross-sections of the device of this modification along lines g-g and h-h shown in Fig. 16A, respectively. Figs. 18 and 19 show the device of this modification when MOSFET 20 is turned off for charging and discharging, respectively. The cross-section for these drawings is along line i-i shown in Fig. 16A. The connections between the terminals are the same as those shown in Figs. 4 and 5.

The low concentration impurity region 17 improves the breakdown voltage application between the source region 12 and the channel layer 3. Fig. 20 shows the same cross-section of the device without the low concentration impurity region 17, i.e., the same cross-section as shown in Fig. 4. In the structure of Fig. 20, when the source S and the back gate BG are connected, a supply potential VDD as high as 20 volts may be applied to the drain D. However, when the back gate BG and the drain D are connected, the maximum supply potential VDD applied to the source S is about 10 volts.

The difference is due to the electric field concentration at the boundary between the source region 12 and the channel layer 3, which gives rise to the reduction of the breakdown voltage. That is, when the source S and the back gate BG are connected, there is no electric field generated in the pn junction because the channel layer 3 and the source region 12 are at the same potential. On the other hand, when the back gate BG and the drain D are connected, an electric field is generated at the pn junction between the channel layer 3 and the source region 12.

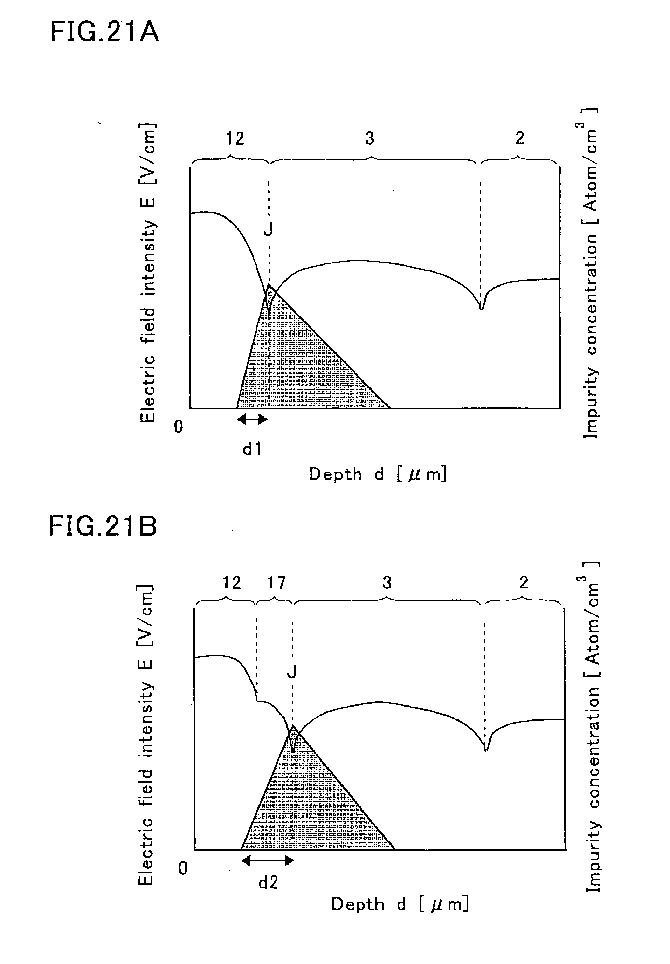

Figs. 21A and 21B show the electric field generated at the boundary between the source region 12 and the channel layer 3, when the back gate BG and the drain D are connected. Fig. 21A corresponds to the device without the low concentration impurity region 17, and Fig. 21B to the device with the low concentration impurity region 17. The two Y axes represent the electric field and the impurity concentration, respectively, and the X axis represents the depth from the top surface of the substrate 100. The shaded area represents the distribution of the electric filed.

As shown in Fig. 21A, the maximum electric filed is at the pn junction J in the device without the low concentration impurity region 17. The distance between the onset of the electric field and the pn junction J is defined as d1. As shown in Fig. 21B, the maximum electric field is also at the pn junction J in the device with the low concentration impurity region 17. However, the low concentration impurity region 17 pushes the onset point further away from the pn junction J. Thus, the distance between the onset point and the pn junction J, d2, is greater than d1, which results in less electric filed concentration at the pn junction J. This improves the breakdown voltage and allows application of a voltage as high as 20 volts to the source S, when the back gate BG and the drain D are connected.

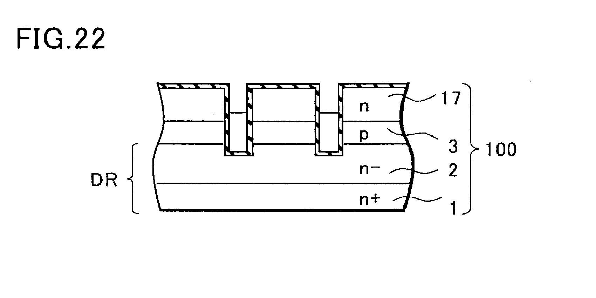

The method of manufacturing the device of the modification to the first embodiment is essentially the same as that described with reference to Figs. 6-11C. The difference is the formation of the low concentration impurity region 17, which is performed between the process step shown in Fig. 9B and the process step shown in Fig. 10A. This additional step is shown in Fig. 22. This cross-section corresponds to that shown in Fig. 17A. Phosphorous (P) impurities are ion-implanted into the corresponding portions of the channel layer 3 using a mask having stripe-patterned openings at a dose of about 5.0×10¹³ cm⁻². An annealing is performed on this device intermediate so that the depth of the low concentration impurity region 17 from the top surface of the substrate 100 is about 0.6 µm.

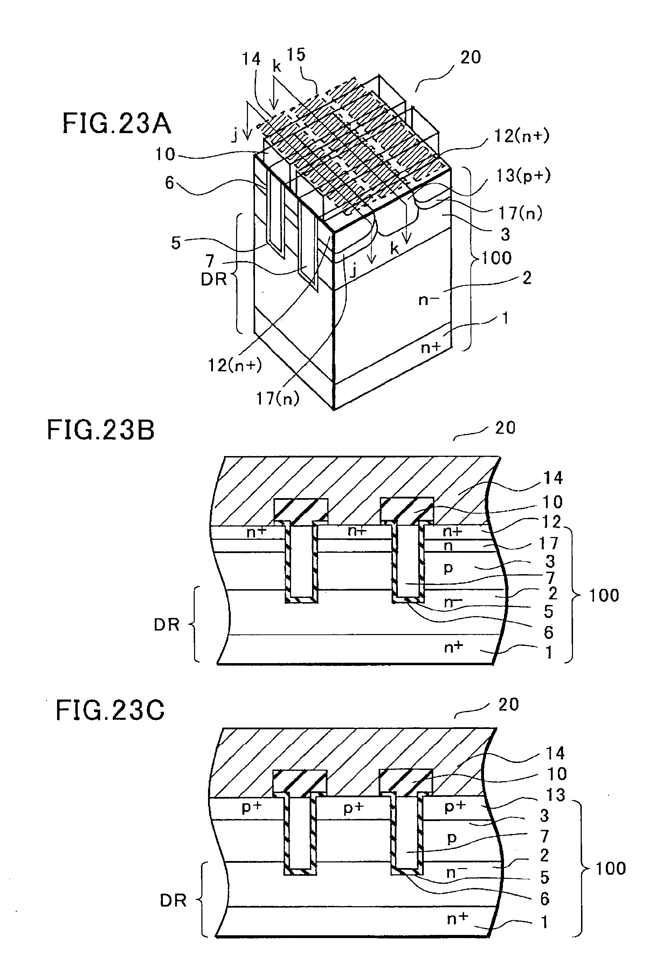

Figs. 23A-23C show one modification to the second embodiment. The modification over the structure shown in Fig. 12A is that a low concentration impurity region 17 is provided between the high concentration region 12 and the channel layer 3. In other words, this modification improves the breakdown voltage application of the device shown in Fig. 12A in the same manner as the modification of the first embodiment improves the breakdown voltage of the device shown in Figs. 1A and 1B. Figs. 23B and 23C are cross-sections of the structure shown in Fig. 23A along lines j-j and k-k, respectively.

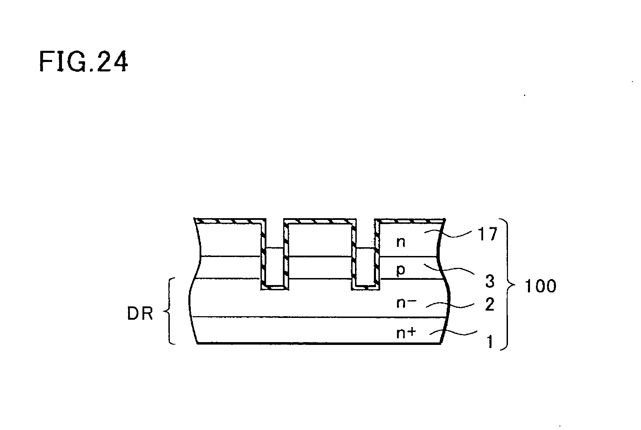

The method of manufacturing the device of the modification to the second embodiment is essentially the same as that of the second embodiment. As is the case with the modification to the first embodiment, the difference is the formation of the low concentration impurity region 17, which is performed between the process step shown in Fig. 13B and the process step shown in Fig. 14A. This additional step is shown in Fig. 24. This cross-section corresponds to that shown in Fig. 17A.
Phosphorous (P) impurities are ion-implanted into the corresponding portions of the channel layer 3 using a mask having stripe-patterned openings at a dose of about 5.0×10¹³ cm⁻². The annealing is performed on this device intermediate so that the depth of the low concentration impurity region 17 from the top surface of the substrate 100 is about 0.6 µm.

According to this embodiment, a source electrode and a drain electrode can be individually connected to a body region (a back gate region). Thus, it is possible to switch between a state where a source region and the back gate region are short-circuited and a state where a drain region and the back gate region are short-circuited, within one MOSFET.

Thus, it is possible to block an unwanted current path (a current path opposite to a desired current path) which is formed by a parasitic diode when the MOSFET is off.

Therefore, it is possible to switch a bidirectional current path and to prevent a reverse current in one chip of the MOSFET.

By burying an interlayer insulating film in a trench, a surface of a substrate can be flattened, with which first and second electrode layers are in contact. Specifically, no step coverage is caused by the interlayer insulating film. Since the first and second electrode layers are formed in a stripe pattern, sufficient contacts with the source region and the body region are achieved, respectively. Thus, it is also possible to secure high adhesion.

Although three masks are used in the steps of forming the source region , the body region and the interlayer insulating film, it is only necessary to take account of misalignment for one mask. Specifically, compared with the conventional case where misalignment for three masks used in three separate steps is taken into consideration, the distance between trenches can be reduced. Therefore, an operation region can be increased.
Thus, if the same chip size is adopted, an on-resistance can be reduced, and, if the same number of cells is used, the chip size can be reduced.

It is possible to realize an element capable of performing a bidirectional switching operation by use of one chip of the MOSFET. For example, where the embodiments of the invention are adopted in a protection circuit of a secondary battery, it is possible to realize reduction in the number of components and miniaturization of the device.

The introduction of the low concentration impurity region reduces the concentration of the electric field at the pn junction and thus increases the breakdown voltage when the drain is connected to the ground, or any other reference voltage.

## Claims

1. An insulated gate semiconductor device comprising:
a drain region comprising a semiconductor substrate (1) of a first general conductivity type and a semiconductor layer (2) of the first general conductivity type disposed on the substrate (1);
a channel layer (3) of a second general conductivity type disposed on the semiconductor layer (2);
a plurality of trenches (5) formed in the channel layer (3) and reaching the drain region through the channel layer (3), the trenches (5) being elongated in a first direction within a primary plane of the substrate (1);
a gate electrode (7) disposed in each of the trenches (5);
a plurality of source regions (12) of the first general conductivity type formed in the channel layer (3) between the trenches (5), the source regions (12) being aligned in a second direction within the primary plane of the substrate (1);
a plurality of body regions (13) of the second general conductivity type formed in the channel layer (3) between the trenches, the body regions (13) being aligned in the second direction, each of the body regions (13) being disposed adjacent a corresponding source region (12);
a plurality of first electrode layers (14) disposed on the source regions (12) so that each of the first electrode layers (14) connects corresponding source regions (12) aligned in the second directions; and
a plurality of second electrode layers (15) disposed on the body regions (13) so that each of the second electrode layers (15) connects corresponding body regions (13) aligned in the second direction.

2. The insulated gate semiconductor device of claim 1, wherein each of the first electrode layers (14) is disposed adjacent a corresponding second electrode layer (15).

3. The insulated gate semiconductor device of claim 1 or 2, further comprising an insulating film (10) disposed in each of the trenches (5) so as to fill a space between a top edge of the trench (5) and a top portion of the gate electrode (7) disposed in the trench (5).

4. The insulated gate semiconductor device according to any of claims 1 to 3, further comprising a third electrode layer attached to the drain region.

5. The insulated gate semiconductor device according to any of claims 1 to 4, further comprising a bidirectional current path formed between the source region (12) and the drain region when a voltage is applied to the gate electrode (7), a direction of current in the bidirectional current path being determined according to potentials of the source and drain regions (12).

6. The insulated gate semiconductor device according to any of claims 1 to 5, wherein the first direction is normal to the second direction.

7. The insulated gate semiconductor device according to any of claims 1 to 6, wherein the source regions (12) and the body regions are aligned alternately along a sidewall of the each of the trenches.

8. The insulated gate semiconductor device according to any of claims 1 to 7, wherein the trenches (5) have the same length in the first direction and the same width in the second direction.

9. The insulated gate semiconductor device according to any of claims 1 to 8, wherein each of the source regions (12) comprises a high concentration impurity region and a low concentration impurity region disposed between the channel layer (3) and the high concentration impurity region.

10. The insulated gate semiconductor device of claim 9, wherein an impurity concentration of the low concentration impurity region is about 1×10¹⁶ cm⁻³ to 1×10¹⁸ cm⁻³.

11. A protection circuit for a secondary battery, comprising:
a switching device comprising a drain region, a drain electrode attached to the drain region, a channel layer (3) disposed on the drain region, a trench (5) formed in the channel layer (3) and extending horizontally in a first direction, a gate electrode (7) disposed in the trench (5), a source region (12) formed in the channel layer (3) adjacent the trench (5), a body region (13) formed in the channel layer (3) adjacent the trench (5), a first electrode (14) in contact with the source region (12) and extending horizontally in a second direction, and a second electrode (15) in contact with the body region (13) and extending horizontally in the second direction, the switching device being connected with the secondary battery; and
a control circuit (24) connected with the switching device (20) and configured to apply voltages separately to the first electrode (14) and the second electrode (15).

12. The protection circuit (24) of claim 11, wherein the control circuit is configured to connect the second electrode (25), when the control circuit (26) stops applying a voltage to the gate electrode, with the first electrode or the drain electrode which is at a lower potential at the time of stopping the voltage application.

13. The protection circuit (24) of claim 12, wherein the control circuit is configured to apply at the time of stopping the voltage application a power supply voltage to the first electrode (14) or the drain electrode (15) which is not at the lower potential.

14. The protection circuit of claim 12, wherein the lower potential is a ground potential.

15. A method of manufacturing an insulated gate semiconductor device, comprising:
providing a semiconductor substrate (1) of a first general conductivity type;
forming a channel layer (3) of a second general conductivity type on the substrate;
forming a plurality of trenches (5) in the channel layer (3) so as to extend in a first direction within a primary plane of the substrate (1);
forming a gate electrode (7) in each of the trenches (5);
forming a plurality of source regions (12) of the first general conductivity type in the channel layer (3) between the trenches (5) so as to be aligned in a second direction within the primary plane of the substrate (1);
forming a plurality of body regions (13) of the second general conductivity type in the channel layer (3) between the trenches (5) so as to be aligned in the second direction;
forming a plurality of first electrode layers on the source regions (12) so that each of the first electrode layers connects corresponding source regions aligned in the second directions; and
forming a plurality of second electrode layers on the body regions so that each of the second electrode layers connects corresponding body regions aligned in the second direction.

16. The method of claim 15, further comprising forming an insulating film (10) in each of the trenches (5) so as to fill a space between a top edge of the trench (5) and a top portion of the gate electrode (7) disposed in the trench (5).

17. The method of claim 15 or 16, further comprising attaching a drain electrode (16) to the substrate.

18. The method according to any of claims 15 to 17, wherein the forming of the source regions 12 comprises forming high concentration impurity regions and low concentration impurity regions disposed between the channel layer and the high concentration impurity regions.

19. The method of claim 18, wherein an impurity concentration of the low concentration impurity regions is about 1×10¹⁶ cm⁻³ to 1×10¹⁸ cm⁻³.
